# EUROPÄISCHE PATENTSCHRIFT

(11) **EP 2 758 251 B1**
(45) Veröffentlichungstag und Bekanntmachung des Hinweises auf die Patenterteilung: **09.10.2019**
(21) Anmeldenummer: 12750590.7
(22) Anmeldetag: 22.08.2012
(51) Int. Cl.: B41N 1/22, B41N 6/00, B32B 1/08, F16L 11/04, B41C 1/05

(54) **DRUCKFORM ZUR VERWENDUNG FÜR DEN HOCHDRUCK, INSBESONDERE DEN FLEXODRUCK**
PRINTING PLATE FOR USE IN RELIEF PRINTING, IN PARTICULAR FLEXO PRINTING
CLICHÉ DESTINÉ À ÊTRE UTILISÉ EN TYPOGRAPHIE, NOTAMMENT EN FLEXOGRAPHIE

(30) Priorität: 19.09.2011 DE 102011053747; 19.09.2011 US 201161536343 P
(43) Veröffentlichungstag der Anmeldung: 30.07.2014
(73) Patentinhaber: ContiTech Elastomer-Beschichtungen GmbH, 30165 Hannover (DE)
(72) Erfinder: FÜLLGRAF, Stefan, 37115 Duderstadt (DE); SENNE, Armin, Ettenheim 77955 (DE)
(74) Vertreter: Finger, Karsten
(86) Internationale Anmeldenummer: PCT/EP2012/066296
(87) Internationale Veröffentlichungsnummer: WO 2013/041318

(56) Entgegenhaltungen:
- EP-A1- 2 070 717
- EP-A2- 1 275 520
- EP-B1- 0 844 100
- WO-A1-2010/011361
- WO-A2-01/87611
- US-A- 5 860 360

## Beschreibung

Die Erfindung betrifft einen Druckformvorläufer zur Verwendung für den Hochdruck, insbesondere den Flexodruck, der als mehrschichtiger Schlauch ausgebildet ist, mit wenigstens einer ersten Schicht, die ein Vulkanisat auf Basis wenigstens eines Elastomers aufweist.

Die Drucktechnik befasst sich mit der Vervielfältigung von Druckvorlagen, indem Druckfarben von einer Druckform auf einen Druckträger wie z.B. Papier, Pappe oder Kunststoff übertragen werden. Hierzu gehört das Verfahren der Hochdrucktechnik, bei dem die Druckelemente erhaben über den Vertiefungen auf der Druckform stehen, d.h. die Bildstellen der Druckform stehen höher als die Nichtbildstellen. Die erhöht ausgebildeten Druckelemente bzw. Bildstellen werden mit der Druckfarbe versehen, wodurch sie die Druckvorlage ausbilden, die dann auf den Druckträger übertragen werden kann, um dort die Druckvorlage abzubilden.

Die Druckform bzw. dessen Druckformvorläufer kann ein ein- oder mehrschichtiges zylindrisches Flächengebilde mit bzw. aus einem elastomeren Material sein, das die indirekte Bildübertragung z.B. im Offsetdruck oder die direkte Bildübertragung z.B. im Flexodruck bewirkt. Das zylindrische Flächengebilde weist als oberste Schicht eine Druckschicht auf, die zum Druckträger hin ausgerichtet ist. Die Druckschicht kann auf einer Festigkeitsträgerschicht vorgesehen sein. Ist die Druckschicht und ggfs. die Festigkeitsträgerschicht flexibel ausgebildet, z.B. durch Photopolymere, so spricht man vom Flexodruckverfahren. Weitere Schichten zwischen der Druckschicht und der optionalen Festigkeitsträgerschicht sind beim Hochdruckverfahren möglich, z.B. in Form einer kompressiblen Schicht. Auch können mehrere kompressible Schichten und Festigkeitsträgerschichten vorgesehen sein, die vorzugsweise abwechselnd angeordnet sind. Alle Schichten bilden herkömmlicherweise untereinander einen Haftverbund, d.h. die einander benachbarten Schichten sind miteinander haftend verbunden, d.h. stoffschlüssig durch z.B. Klebemittel oder durch Vulkanisation.

Die Ausbildung der erhöhten Druckelemente bzw. Bildstellen der Druckvorlage kann beim Hochdruckverfahren und insbesondere beim Flexodruckverfahren mittels Lasergravur erfolgen. Hierzu weist die Druckschicht Photopolymere auf. Unter Photopolymeren werden lichtaushärtende Kunststoffe wie z.B. Epoxidharze verstanden. Alternativ können die erhöhten Druckelemente bzw. Bildstellen auch durch mechanische Bearbeitung wie z.B. mittels Fräsen auf der Druckschicht erzeugt werden.

Zur Durchführung des Druckens kann das zylindrische Flächengebilde als Druckform auf einem Druckzylinder montiert werden, um mittels der erhöhten Druckelemente bzw. Bildstellen fortlaufend Druckfarbe auf den Druckträger zu übertragen. Derartige Anordnungen werden auch Hülsen, Druckhülsen, Sleeve oder auch Trägersleeve genannt und zur Herstellung von Endlosmotiven wie z.B. Tapeten, Servietten oder Geschenkpapier verwendet.

Die Herstellung derartiger mehrschichtiger zylindrischer Flächengebilde als Druckform erfolgt derart, dass sich auf der Oberfläche, d.h. Druckschicht, keine Naht oder dergleichen ausbildet. Entsprechend ist es bisher üblich, eine zylindrische Druckform auf einem nicht bzw. nur geringfügig dehnbaren Festigkeitsträger wie z.B. einem GFK-Körper (Glasfaserverstärkter Kunststoff) durch Wickeln oder Bandagieren von elastomeren Schichten oder Bahnen aufzubauen und dann zu vulkanisieren. Auch können Nickel- oder Stahlzylinder als starre Grundkörper verwendet werden, um auf diesen als Festigkeitsträger die elastomere Druckschicht aufzubauen.

Aufgrund von fertigungsbedingten Unebenheiten und unterschiedlichen Schichtdicken des elastomeren Materials in radialer Richtung ist es dabei erforderlich, die vulkanisierte zylindrische Druckform mittels z.B. Schleifen auf die gewünschten Schichtdicke und Oberflächenqualität zu bringen. Schließlich kann die Hülse, d.h. der Festigkeitsträger mit vulkanisierter zylindrischer Druckform, auf die gewünschte Länge geschnitten und ausgeliefert werden. Anschließend kann die Hülse beim Graveur in eine entsprechende Vorrichtung eingespannt und durch Abtrag der Vertiefungen bzw. Nichtbildstellen die Druckvorlage (Druckrelief, Tiefengravur) herausgearbeitet werden. Dieser Abtrag kann z.B. durch Laser oder Fräser erfolgen.

Zur Anwendung wird dann in der Druckerei die Hülse auf den Druckzylinder geschoben und dort gehalten. Dies kann mittels mechanischer Klemmelemente, Klebemittel, Ansaugtechnik oder magnetischer Kräfte erfolgen. Wichtig ist dabei, dass die Hülse sich auch bei hohen Umdrehungsgeschwindigkeiten nicht in radialer sowie axialer Richtung von dem Druckzylinder lösen kann und auch seine Positionierung auf dem Druckzylinder sicher beibehält.

Nachteilig ist bei der bisher üblichen Herstellung von Hülsen, dass die Druckschicht nach dem Abtrag zur Ausbildung der erhöhten Druckelemente bzw. Bildstellen lediglich zur Abbildung eben dieser einen Druckvorlage verwendet werden kann. Soll eine andere Druckvorlage abgebildet werden, wird die bisherige Druckform unbrauchbar und mit ihr auch der entsprechende Festigkeitsträger, da dieser durch den vulkanisierten gewickelten Aufbau nicht bzw. nur mit großem Aufwand wieder von der Druckschicht getrennt werden kann. Somit ist zur Erzeugung einer neuen Druckvorlage gemäß der zuvor beschriebenen bekannten Herstellung stets ein neuer Festigkeitsträger zu verwenden, auf dem dann eine neue Druckform aufgebaut und anschließend auf dieser die neue Druckvorlage hergestellt wird.

Nachteilig ist auch, dass die zuvor beschriebene bekannte Herstellung mit sehr vielen Schritten verbunden ist, von denen mehrere durch Handarbeit ausgeführt werden müssen, d.h. wenig bis gar nicht automatisiert durchgeführt werden können. Dies führt gerade in Hochlohnländern zu erheblichen Kosten bei der zuvor beschriebenen bekannten Herstellung, die sich in entsprechend hohen Preisen der Hülsen niederschlagen.

Nachteilig ist ferner, dass die Hülse als Endprodukt der zuvor beschriebenen bekannten Herstellung stets ein starrer Körper mit einem durch den zylindrischen Festigkeitsträger eingeschlossenen großen hohlen Volumen im Vergleich zu der Hülse selbst darstellt. Somit ist zur Lagerung und zum Versand ein weitaus größeres Volumen erforderlich, als durch die Hülse selbst eingenommen wird.

Die US 5 860 360 A beschreibt eine auswechselbare Hülse mit einer Arbeitsfläche, die an einem Träger montiert werden kann. Die Hülse enthält eine innere Polymerschicht, eine die innere Schicht überlagernde Verstärkungsschicht, eine die Verstärkungsschicht überlagernde Polymerzwischenschicht und eine äußere Polymerschicht. Die Hülse kann eine Polsterschicht zwischen der Zwischenschicht und der äußeren Schicht umfassen. Die Schichten, die die Hülse umfassen, werden um einen Träger herum gebildet und dann gleichzeitig in einem einzigen Schritt ausgehärtet. Die resultierende Hülse kann bei Druckvorgängen oder bei anderen Anwendungen wie Beschichtung, Prägung, Laminierung, Kalandrierung und dergleichen verwendet werden.

Die WO 2010 011 361 A1 beschreibt eine Flexodruckhülse oder -platte, welche durch ein Verfahren hergestellt wird, das das Bereitstellen eines mahlbaren Polyurethans, das Vernetzen des fräsbaren Polyurethans und Bilden eines Reliefs durch Lasergravur des vernetzten mahlbaren Polyurethans umfasst. Zum Beispiel kann die Vernetzung durch ein Verfahren auf Peroxidbasis oder durch ein Vulkanisationsverfahren unter Verwendung von Schwefel erreicht werden. Ein Relief wird in einem Beispiel durch Extrudieren des mahlbaren Polyurethans auf eine Nickelhülse, durch thermisches Vernetzen des Polyurethans nach dem Extrusionsschritt und durch Lasergravieren des vernetzten mahlbaren Polyurethans gebildet. Ein Druckartikel wird in die Form einer flachen Druckplatte oder einer durchgehenden Runddruckhülse geformt.

Die Aufgabe der vorliegenden Erfindung ist es, eine Druckform bzw. einen Druckformvorläufer der eingangs beschriebenen Art bereit zu stellen, so dass wenigstens die genannten Nachteile überwunden werden, insbesondere eine Druckform bzw. einen Druckformvorläufer bereitzustellen, die kostengünstiger als bisher bekannt hergestellt werden kann.

Die Aufgabe wird erfindungsgemäß durch einen Druckformvorläufer mit den Merkmalen des Anspruchs 1 sowie durch eine Druckform mit den Merkmalen des Anspruchs 4 gelöst. Vorteilhafte Weiterbildungen sind in den jeweiligen Unteransprüchen beschrieben.

Somit betrifft die vorliegende Erfindung einen Druckformvorläufer zur Verwendung für den Hochdruck, insbesondere den Flexodruck, der als mehrschichtiger Schlauch ausgebildet ist, mit wenigstens einer ersten Schicht, die ein Vulkanisat auf Basis wenigstens eines Elastomers aufweist, wobei die erste Schicht extrudiert ist.

Unter dem Begriff der "Extrusion" wird hier die Extrusion im Sinne der Verfahrenstechnik verstanden. Hierbei werden Kunststoffe oder andere zähflüssige härtbare Materialien wie z. B. Elastomere (z.B. Kautschuk, Gummi) in einem kontinuierlichen Verfahren durch eine speziell geformte Düse gepresst. Es entstehen Körper mit dem Querschnitt der Düse in beliebiger Länge. Durch Extrusion können z.B. nahtlose Platten, Rohre, Schläuche und Profile mit über der Länge konstantem Querschnitt hergestellt werden. Beispielsweise wird ein extrudierter Schlauch von einer Form umschlossen und mittels Druckluft an die Werkzeugwand geblasen. In diesem Fall spricht man von Extrusionsblasformen.

Der Erfindung liegt die Erkenntnis zugrunde, dass eine Druckform bzw. dessen Druckformvorläufer für den Hochdruck, insbesondere den Flexodruck, als ein- oder mehrschichtiges zylindrisches Flächengebilde herkömmlich vergleichsweise aufwendig dafür hergestellt wird, dass sie im Wesentlichen aus einer elastomeren bzw. elastomerhaltigen Schicht bestehen, wie sie bei Schläuchen üblich ist. Somit wird eine Druckform bzw. dessen Druckformvorläufer wie ein extrudierter Schlauch hergestellt. Hierdurch können die bekannten und erprobten Verfahren zur Schlauchherstellung genutzt werden, um auf diese Weise eine elastomere bzw. elastomerhaltige Druckform einfacher und kostengünstiger als bisher üblich herzustellen. So kann die erfindungsgemäße Druckform als elastischer Schlauch unabhängig von dem bisher üblicherweise verwendeten Festigkeitsträger, der u.a. bei der Herstellung beim Wickeln oder Bandagieren als Unterlage dient, hergestellt, gehandhabt, gelagert, transportiert und verwendet werden. Unter dem Begriff "Schlauch" wird im Sinne dieser Erfindung eine flexible Leitung zur Förderung fester, flüssiger und gasförmiger Stoffe verstanden. Im Unterschied zu einem starren Rohr ist eine Leitung flexible, d.h. biegsam, ausgebildet.

Vorzugsweise wird zur Herstellung der ersten extrudierten Schicht ein elastomeres Material verwendet, welches unter der Produktbezeichnung AA6FIZ von der Firma Gummiwerk Kraiburg GmbH & Co. KG hergestellt und vertrieben wird.

Vorteilhaft ist hierbei, dass das Extrudieren von Schläuchen ein gängiges, erprobtes, bekanntes und weit verbreitetes Verfahren ist. Auf diese Weise können vorhandene Produktionseinrichtungen ohne bzw. mit geringem Veränderungsaufwand dazu verwendet werden, eine Druckform als ein- oder mehrschichtiges zylindrisches Flächengebilde mit Verfahrensschritten der Schlauchherstellung zu fertigen. Dies führt zu geringen Herstellungskosten und auch zu einer hohen Produktqualität, da auf die bereits vorhanden Erfahrungen bei der Schlauchherstellung zurückgegriffen werden kann.

Ferner ist hierbei insbesondere vorteilhaft, dass die Schlauchherstellung ein weitestgehend automatisiert ablaufendes Herstellungsverfahren ist im Gegensatz zu dem bekannten gewickelten und bandagierten Aufbau der Druckform auf einem Festigkeitsträger, der zahlreiche manuelle Schritte erfordert. Somit können auch aus diesem Grund erfindungsgemäß die Herstellungskosten für eine Druckform reduziert werden.

Die elastische Druckform bzw. dessen Druckvorläufer kann einfach auf einem Druckzylinder oder dergleichen montiert werden, um es für ein Druckverfahren zu nutzen.

Die elastische Druckform stellt einen zylindrischen Körper dar, der eingefaltet oder eingedrückt werden kann, um sein Volumen zu reduzieren und hierdurch Lager- oder Transportraum einzusparen. Aufgrund seiner elastischen Eigenschaften kann sich die elastische Druckform jedoch wieder auf ihre zylindrische Form ausdehnen, ohne dass ihre Form oder Oberfläche durch das Einfalten oder Eindrücken beschädigt wurden. Dies erleichtert und vergünstigt die Handhabung, die Lagerung und den Transport einer erfindungsgemäßen Druckform.

Ferner weist die Druckform eine weitere Schicht auf, die als Festigkeitsträgerschicht ausgebildet ist.

Vorteilhaft ist hierbei, dass diese Festigkeitsträgerschicht die Stabilität der Druckform erhöht und es hierdurch belastbarer, robuster und einfacher handhabbar macht. Dabei kann die Festigkeitsträgerschicht eine Art von Festigkeitsträger oder mehrere verschiedene Arten von Festigkeitsträgern wie ein oder mehrere Textilgebilde wie z.B. Gestrick, Gewirke oder Gewebe der gleichen Ausgestaltung oder verschiedener Ausgestaltungen aufweisen. Diese können z.B. in einem polymeren Werkstoff, vorzugsweise in einem vulkanisierten polymeren Werkstoff, eingebettet sein, d.h. von diesem umgeben sein bzw. gegenüber der ersten Schicht einen solchen aufweisen. Als Festigkeitsträgerschicht kann auch eine Folie wie z.B. eine Polymerfolie (z.B. Polyamidfolie) oder Metallfolie zur Anwendung gelangen. Bei einer Druckform mit vielen Schichten und wenigstens zwei Festigkeitsträgerschichten kann auch eine Kombination von einem Textilgebilde und einer Folie oder eines Folienverbundes umgesetzt werden.

Bevorzugt ist es hierbei, wenn die erste Schicht und die Festigkeitsträgerschicht ineinander übergehen bzw. die Festigkeitsträgerschicht als Teilbereich der ersten Schicht ausgebildet ist. Dies kann dadurch erreicht werden, dass bei der Extrusion die erste Schicht auf die Festigkeitsträgerschicht aufextrudiert wird und sich vor dem Vulkanisieren diese durchdringt, so dass nach dem Vulkanisieren zumindest ein Teilbereiche, vorzugsweise der in radialer Richtung R dem Inneren der Druckform zugewandte Teilbereich der ersten Schicht, von der Festigkeitsträgerschicht durchdrungen ist.

Gemäß einem weiteren Aspekt der Erfindung weist die Druckform eine weitere Schicht auf, die als kompressible Schicht ausgebildet ist.

Dies ist vorteilhaft, weil auf diese Weise die kompressible Schicht - auch Kompressionsschicht genannt - der Vermeidung eines Walkprozesses durch Volumenverminderung in der Druckzone und zur Kompensation von Eindrückungsunterschieden dient. Bei der kompressiblen Schicht ist entscheidend, dass sie sich beim Zusammendrücken nicht ausdehnt, d.h. dass sich ihr Volumen beim Zusammendrücken tatsächlich verkleinert, damit keine sich seitlich ausbreitenden Verwerfungen entstehen. Verwendet werden können hier beispielsweise Mikrokugeln aus Kunststoff in einer Gummimischung oder ein mikroporöses Zellengebilde mit eingeschlossenen Gaskammern (Schaumstoffe). Die diesbezüglichen Werkstoffe sind insbesondere Polyurethane, vernetzte Polyethylene, Polypropylene, NBR, Neoprene und EPM. Der Elastizitätsmodul liegt zumeist im Bereich von 1 MPa bis 1000 MPa. Hinsichtlich weiterer Details zu der kompressiblen Schicht wird insbesondere auf die Druckschriften EP 0 844 100 B1 und EP 2 070 717 A1 verwiesen, deren Offenbarung Bestandteil der vorliegenden Erfindung ist.

Eine oder mehrere kompressible Schichten werden üblicherweise zwischen der Druckform oder der Hülse (Sleeve) und dem Druckzylinder vorgesehen. Hierzu kann herkömmlich einerseits ein doppelseitiges Klebeband zwischen der Druckform oder der Hülse (Sleeve) und dem Druckzylinder verwendet werden, welches jedoch den Nachteil aufweist, dass es neben der Dämpfungswirkung eine Haftung erzeugt und das Entfernen der Druckform bzw. der Druckhülse erschwert bzw. hierbei Rückstände auf dem Druckzylinder hinterlässt. Zum anderen können herkömmlich entsprechende Adapter verwendet werden, die als separate Elemente zwischen der Druckform oder der Hülse (Sleeve) und dem Druckzylinder angeordnet werden. Diese verursachen zusätzlich Kosten und ihr Einbringen bzw. Entfernen erfordert einen zusätzlichen Aufwand.

Daher ist es vorteilhaft, eine kompressible Schicht oder mehrere kompressible Schichten als Bestandteil der Druckform selbst vorzusehen. Auf diese Weise kann die kompressible Schicht bzw. können die kompressiblen Schichten zusammen mit der Druckform z.B. durch Druckluft von Innen oder Ansaugen mittels eines Vakuums von Außen auf einen Druckzylinder aufgebracht und auch wieder rückstandslos entfernt werden. Ferner kann auf einen separaten Adapter verzichtet werden.

Gemäß einem weiteren Aspekt der Erfindung weist wenigstens eine Schicht ein magnetisches oder magnetisierbares Material auf.

Hierzu können beispielsweise Eisenspäne, metallische oder magnetische Partikel oder ein magnetisches Pulver in das Material einer Schicht der Druckform eingebracht worden sein. Dies ist vorteilhaft, da auf diese Weise die Druckform mittels magnetischer Kraft auf einer Unterlage wie z.B. einem Druckzylinder gehalten werden kann. Hier werden bisher üblicherweise Klebemittel verwendet. Die können jedoch aufquellen, d.h. ihre Form insbesondere in der Höhe verändern und dadurch Bereiche der Druckform anheben. Hierdurch können Vertiefungen bzw. Nichtbildstellen derart angehoben werden, dass sie ungewollt als erhöhte Druckelemente bzw. Bildstellen wirken und damit die Druckvorlage verändern und den Druckträger unbrauchbar machen, da anstelle des gewollten Druckbildes ein anderes erzeugt wird.

Hierzu können beispielsweise Eisenspäne oder ein magnetisches Pulver in das Material einer Schicht der Druckform verwendet werden. Diese Schicht mit magnetischem oder magnetisierbarem Material kann dabei die erste Schicht als Druckschicht selbst sein, eine separate weitere Schicht, deren wesentliche Aufgabe es ist, das magnetische oder magnetisierbare Material aufzunehmen oder auch eine weitere Schicht wie eine Festigkeitsträgerschicht oder kompressible Schicht, die zusätzlich zu ihrer stabilisierenden bzw. dämpfenden Wirkung zusätzlich das magnetische oder magnetisierbare Material aufnimmt.

Auch können die magnetische oder magnetisierbare Eigenschaft der Druckform dazu verwendet werden, die Druckform durch in radialer Richtung R wirkende magnetische Kräfte zu dehnen, es in dem gedehnten Zustand über einen Druckzylinder oder dergleichen zu führen und dann die magnetischen Kräfte wieder zu entfernen, so dass die Dehnung der Druckform aufgehoben wird und sich die Druckform wieder zusammenzieht, wodurch sie auf dem Druckzylinder oder dergleichen sicher positioniert wird. Hierzu kann einerseits in radialer Richtung R von Außen eine magnetische Kraft angelegt werden, die die Druckform nach Außen zieht und hierdurch dehnt. Andererseits kann auch durch den Druckzylinder oder dergleichen eine abstoßende magnetische Kraft erzeugt werden, die die Druckform abstößt und hierdurch dehnt.

Die Erfindung betrifft ferner einen Druckzylinder zur Verwendung für den Hochdruck, insbesondere den Flexodruck, mit einem Druckformformvorläufer wie zuvor beschrieben, wobei die Druckform wenigstens bereichsweise direkt auf der Oberfläche des Druckzylinders in radialer Richtung R aufgebracht ist.

Unter dem Begriff "Druckzylinder" ist eine Druckform zu verstehen, die aus einem zylindrischen Körper besteht, auf dessen Oberfläche in radialer Richtung R nach Außen gerichtet eine Druckvorlage vorgesehen ist. Beispielsweise kann ein Druckzylinder aus einem Stahlhohlkern und einer mit Kupfer beschichteten Oberfläche bestehen. Ein Druckzylinder kann auch als Druckdorn bezeichnet werden.

Vorteilhaft ist bei der Verwendung eine erfindungsgemäße Druckform direkt auf einem Druckzylinder, dass auf Festigkeitsträger und sonstige weitere Schichten der Druckform, wie sie herkömmlich üblich sind, verzichtet werden kann. Dies führt zu einer Vereinfachung der Herstellung, Handhabung, Lagerung etc. der Druckform mit entsprechenden Kostenersparnissen, insbesondere bei der Herstellung.

Die elastische Druckform kann dabei z.B. mittels Druckluft von Innen oder Ansaugen mittels eines Vakuums von Außen geweitet und so auf den Druckzylinder aufgebracht und auch wieder von diesem entfernt werden. Auf diese Weise kann auf Klebemittel zwischen der Unterseite bzw. Innenseite der Druckform und der Oberfläche bzw. Außenseite des Druckzylinders verzichtet werden, um eine Relativbewegung zwischen diesen zu vermeiden. Durch den Verzicht auf Klebemittel werden Material und Zeit zum Auftrag dieser Mittel eingespart, wodurch sich die Kosten und der Aufwand zur Verwendung einer erfindungsgemäßen Druckform für den Anwender in der Druckerei reduzieren. Ferner kann die erfindungsgemäße Druckform mittels Druckluft von Innen oder Ansaugen mittels eines Vakuums von Außen auch wieder rückstandslos von der Oberfläche des Druckzylinders entfernt werden.

Dabei ist vorzugsweise die Elastizität der erfindungsgemäßen Druckform derart vorzusehen, z.B. mittels einer entsprechenden Materialauswahl bzw. Materialmischung zumindest der elastomeren Bestandteile der ersten Schicht, dass einerseits eine Dehnung der Druckform so weit möglich ist, dass die Druckform auf einen Druckzylinder aufgebracht (z.B. aufgeschoben) werden kann, und andererseits die Druckform auf dem Druckzylinder sicher gehalten wird. Unter einem sicheren Halt ist zu verstehen, dass die Druckform gegenüber dem Druckzylinder auch unter der Einwirkung von Torsionskräften und Fliehkräften keine Relativbewegung ausführt. Fliehkräfte können z.B. durch die Rotation des Druckzylinders auftreten. Torsionskräfte können z.B. durch eine mechanische Bearbeitung wie z.B. Schleifen, Finishen, Polieren und dergleichen der Oberfläche der Druckform zur Ausarbeitung der Druckform (Druckrelief) entstehen.

Alternativ kann die erfindungsgemäße Druckform auch mittels Klebemittel auf der Oberfläche des Druckzylinders fixiert werden, nachdem es mittels Druckluft von Innen oder Ansaugen mittels eines Vakuums von Außen geweitet und auf den Druckzylinder aufgebracht wurde. So kann die Druckform mittels einer Kombination aus Elastizität seines Materials und Haftwirkung des Klebemittels auf dem Druckzylinder gegen Relativbewegungen gesichert werden. Dabei ist die Haftwirkung des Klebemittels vorzugsweise so bemessen vorzusehen, dass sowohl eine sichere Fixierung gegenüber angreifenden Flieh- und bzw. oder Torsionskräften erfolgt als auch die Druckform mittels Druckluft von Innen oder Ansaugen mittels eines Vakuums von Außen wieder von dem Druckzylinder - möglichst rückstandslos - entfernt werden kann.

Ferner kann in dem Material der Druckform auch ein magnetisches oder magnetisierbares Material vorgesehen sein. In diesem Fall kann eine sichere Fixierung der erfindungsgemäßen Druckform gegenüber dem Druckzylinder auch zusätzlich oder alternativ zu den zuvor beschriebenen Möglichkeiten mittels magnetischer Anziehungskräfte erfolgen.

Auch kann ein sicherer Halt zwischen Druckform und Druckzylinder dadurch bewirkt werden, dass die Druckform eine Schicht aufweist, die in radialer Richtung R unterhalb der Druckschicht angeordnet ist und dazu veranlasst werden kann, sich zusammenzuziehen, d.h. zu schrumpfen. Hierzu kann eine Schrumpffolie verwendet werden, die sich bei Erwärmung zusammenzieht, d.h. schrumpft. Derartige Materialien sind z.B. durch Schrumpfschläuche bekannt, die über elektrische Verbindungsstellen gezogen und mittels heißer Luft, z.B. durch einen Föhn, geschrumpft werden, um die elektrischen Verbindungsstellen abzudichten. Vorzugsweise ist eine weitere Schicht der Druckform wie z.B. eine Festigkeitsträgerschicht als schrumpfbare Schicht ausgebildet.

Auch kann ein sicherer Halt durch ein Gewebe, Gestrick oder Geflecht erzeugt werden, welches z.B. als Festigkeitsträgerschicht in der Druckform vorgesehen ist. Zu diesem Zweck kann das Gewebe, Gestrick oder Geflecht einen verschränkten Verlauf aufweisen, so dass z.B. durch Zusammenschieben in axialer Richtung A die Druckform sich in radialer Richtung R ausdehnt und das Gewebe, Gestrick oder Geflecht sich hierdurch lockert. In diesem Zustand kann die Druckform z.B. auf einen Druckzylinder oder dergleichen aufgeschoben werden. Anschließend kann das Zusammenschieben aufgehoben werden, wodurch sich die Druckform in axialer Richtung A wieder ausdehnt und sich das verschränkte Gewebe, Gestrick oder Geflecht spannt, so dass die Druckform sicher auf dem Druckzylinder oder dergleichen gehalten wird. Dieses Prinzip eines verschränkten Gewebes, Gestricks oder Geflechts ist auch als "Fingerfalle" bekannt. Hierbei wird die Hysteresespannung des verschränkten Gewebes, Gestricks oder Geflechts ausgenutzt und im nicht-zusammengeschobenen Zustand eine Klemmung gegenüber dem Druckzylinder erreicht.

Ferner kann auch eine Schicht oder Beschichtung auf der in radialer Richtung R inneren Seite der Druckform mit einer antirutschenden Eigenschaft ausgebildet sein, um hierdurch einen sicheren Halt herzustellen. Dies kann durch Materialeigenschaften dieser Schicht oder Beschichtung ebenso erreicht werden wie durch dessen Oberflächenbeschaffenheit.

Die Erfindung betrifft ebenso eine Hülse zur Verwendung für den Hochdruck, insbesondere den Flexodruck, mit einem Festigkeitsträger, insbesondere einem formstabilen Festigkeitsträger, und einer Druckform bzw. einem Druckformvorläufer wie zuvor beschrieben.

Unter dem Begriff "Hülse" ist eine Druckhülse, ein Sleeve oder auch ein Trägersleeve zu verstehen, wie sie in der Drucktechnik eingesetzt wird, um eine Druckform, insbesondere eine Druckschicht, auf einem Druckzylinder zu montieren. Unter diesem Begriff wird die auswechselbare äußere Schale bei Tiefdruck- oder Flexodruckzylindern verstanden.

Vorteilhaft ist bei diesem Aufbau einer Hülse, dass die erfindungsgemäße Druckform in Kombination mit einem Festigkeitsträger, insbesondere einem formstabilen Festigkeitsträger, verwendet werden kann, um eine Hülse zu bilden, die wie die bisher üblich hergestellten Hülsen verwendet werden kann. Auf diese Weise wird die erfindungsgemäß hergestellte und aufgebaute Druckform einfacher, schneller und günstiger produziert als bisher üblich, das an den Kunden gelieferte Produkt der Hülse weist für diesen jedoch keinerlei bzw. vernachlässigbare Unterschiede und die erforderliche Qualität auf. Hierdurch kann auch die Akzeptanz des Produktes der Hülse beim Anwender erhöht und die Kostenersparnis der erfindungsgemäßen Herstellung bzw. des erfindungsgemäßen Aufbaus durch den Anwender genutzt werden.

Die Erfindung betrifft auch ein Verfahren zur Herstellung einer Druckform bzw. eines Druckformvorläufers wie zuvor beschrieben, mit wenigstens den folgenden Schritten:
in einem ersten Schritt, Extrudieren einer ersten Schicht der Druckform, wobei die erste Schicht ein Vulkanisat auf Basis wenigstens eines Elastomers aufweist, und
in einem weiteren Schritt, Aufbringen der Druckform auf einen zylindrischen Körper.

Dieses Verfahren betrifft die Herstellung einer Druckform, wie es an eine Druckerei, einem Graveur oder dergleichen geliefert wird, um auf dieser Druckform eine Druckvorlage auszubilden und diese dann als Druckvorlage zum Drucken zu verwenden. Hierzu wird erfindungsgemäß die Druckform in einem ersten Schritt in Form einer ersten Schicht extrudiert. Die Druckform wird dann in einem nachfolgen Schritt auf einen zylindrischen Körper aufgezogen, welcher ein Druckzylinder oder auch eine Halterung für einen weiteren Bearbeitungsschritt sein kann. Die Druckform kann auch auf einen Festigkeitsträger, vorzugsweise einen formstabilen Festigkeitsträger, aufgebracht und in dieser Form auf einen Druckzylinder oder für einen weiteren Bearbeitungsschritt auf eine Halterung aufgebracht werden.

Vorzugsweise wird hierbei die Druckform auf den Druckzylinder aufgebracht, indem es von Innen mittels Druckluft oder von Außen mittels eines Vakuums gedehnt und in diesem Zustand über den Festigkeitsträger aufgebracht wird.

Zu diesem ersten Schritt gehört es erfindungsgemäß auch, dass das Extrudieren der wenigstens ersten Schicht auf eine Festigkeitsträgerschicht wie z.B. ein Gestrick, Geflecht oder Gewirk erfolgt. Hierzu kann in einer entsprechenden Fertigungsanlage das Erstellen der Festigkeitsträgerschicht z.B. auf einem Dorn oder dergleichen erfolgen, auf die dann anschließend die wenigstens erste Schicht aufextrudiert wird.

Gemäß einem Aspekt der Erfindung weist das Verfahren zur Herstellung einer Druckform den anschließenden Schritt auf:
Verringern der Schichtdicke der ersten Schicht der Druckform.

Diesem Verfahrensschritt liegt die Erkenntnis zugrunde, dass eine Druckform mit einer extrudierten ersten Schicht i.A. noch nicht die Schichtdicke und eventuell auch nicht die Oberflächenbeschaffenheit aufweist, die eine Druckform besitzen muss, um in der Drucktechnik verwendet werden zu können. Insbesondere ist bei einer zylindrischen Druckform deren Rundlauf ein wichtiges Qualitätskriterium. Vielmehr weist die erfindungsgemäße Druckform nach dem Extrudieren verfahrensbedingt bzw. gewünscht eine zumindest geringfügige Überdimensionierung in radialer Richtung R auf, d.h. eine größere Schichtdicke als die fertige Druckform.

Auf diese Weise kann erfindungsgemäß in einem entsprechenden Verfahrensschritt zur Herstellung einer Druckform diese Überdimensionierung z.B. durch einen spanenden Abtrag wie z.B. Drehen oder Schleifen beseitigt werden. Vorzugsweise wird die Überdimensionierung in radialer Richtung R mittels Schleifens abgetragen, da hierdurch eine sehr feine Einstellung der gewünschten Schichtdicke und gleichzeitig eine vergleichsweise gleichmäßige Oberflächenqualität erreicht werden kann.

Hierzu ist es vorteilhaft, die extrudierte Druckform auf eine zylindrische Halterung z.B. mittels Druckluft von Innen oder Ansaugen mittels eines Vakuums von Außen aufzuziehen, die Druckform auf dieser zylindrischen Halterung in einer entsprechenden Fertigungsanlage rotieren zu lassen und dabei das überschüssige Material z.B. abzudrehen oder abzuschleifen.

Zusätzlich oder alternativ kann in einem solchen Schritt auch die Oberflächenbeschaffenheit der Druckform bearbeitet werden, z.B. durch Schleifen, Polieren oder Finishen, vorzugsweise durch Schleifen. Diese beiden Verfahrensschritte können vorzugsweise zeitgleich und in derselben Fertigungsanlage erfolgen, wobei die entsprechenden Werkzeuge derart angeordnet sind, dass die rotierende, zu bearbeitende Druckform zuerst hinsichtlich seiner Schichtdicke und anschließenden gegebenenfalls hinsichtlich seiner Oberflächenqualität bearbeitet wird.

Dabei wird besonders bevorzugt das Schleifen sowohl für die Einstellung der Schichtdicke als auch die Herstellung der gewünschten Oberflächenbeschaffenheit verwendet, weil auf diese Weise zwei Verfahrensschritte mittels eines Werkzeugs kombiniert werden können, d.h. das Schleifen führt gleichzeitig zwei Verfahrensschritte an derselben Stelle der Druckform aus. Hierdurch kann der Aufwand der Herstellung einer Druckform reduziert und deren Qualität verbessert werden.

Besonders bevorzugt kann ein erfindungsgemäßes Verfahren zur Herstellung einer Druckform bzw. einem Druckformvorläufer folgendermaßen ablaufen:
In einem ersten Schritt kann eine erste Schicht der Druckform durch extrudieren hergestellt werden, wobei die erste Schicht ein Vulkanisat auf Basis wenigstens eines Elastomers aufweist. Das Extrudieren der ersten Schicht kann vorzugsweise auf einem Untergrund wie z.B. einem Dorn erfolgen, wie sie üblicherweise für die Schlauchherstellung verwendet werden. Dabei erfolgt das Extrudieren der ersten Schicht auf einen Dorn, auf dem zuvor eine Festigkeitsträgerschicht in Form eines Gestricks, Geflechts oder Gewirkes aufgebracht wurde.

In einem weiteren Schritt kann die erste Schicht ggfs. von dem Dorn z.B. mittels Druckluft von Innen oder Ansaugen von Außen entfernt und danach auf die gewünschte Länge in axialer Richtung A zugeschnitten werden, wie sie für die Druckform erforderlich ist.

In einem weiteren Schritt kann die Druckform auf einen zylindrischen Körper aufgebracht werden. Dies ist vorzugsweise eine Halterung als Hilfsmittel, um die Druckform bei den weiteren Herstellungsschritten handhaben zu können. Dies kann ebenfalls z.B. mittels Druckluft von Innen oder Ansaugen von Außen erfolgen.

In einem weiteren Schritt kann die Druckform mittels der Halterung in eine Fertigungsanlage eingespannt werden, in der die Druckform rotiert werden kann. In dieser Fertigungsanlage können dann vorzugsweise mittels Schleifens zum Einen die gewünschte Schichtdicke und damit der Rundlauf der zylindrischen Druckform durch Abtrag von überschüssigem Material in radialer Richtung R erfolgen. Zum Anderen kann durch das Schleifen auch gleichzeitig eine gewünschte Oberflächenbeschaffenheit der ersten Schicht als Druckschicht der Druckform eingestellt werden.

In einem weiteren Schritt kann die Druckvorlage (Tiefengravur) auf der Druckschicht der Druckform herausgearbeitet werden. Dies kann durch Abtrag der Vertiefungen bzw.

Nichtbildstellen der Druckvorlage erfolgen, so dass lediglich die Druckelemente bzw. Bildstellen der Druckvorlage in radialer Richtung R erhöht nach dem Abtrag verbleiben, um die Druckfarbe auf den Druckträger zu übertragen. Vorzugsweise erfolgt der Abtrag mittels Laserbearbeitung.

Hierbei ist es bevorzugt, wenn der Schritt des Schleifens und des Abtragens in derselben Fertigungsanlage erfolgen. Dies hat den Vorteil, dass kein Umspannen der Halterung samt Druckform oder sogar Wechseln der Druckform von einer Halterung auf eine andere zwischen der Herstellungsschritten erforderlich ist. Hierdurch wird zum Einen der zeitliche Aufwand reduziert. Zum Anderen werden weniger Halterungen benötigt. Dies beides reduziert den Herstellungs- und auch Logistikaufwand und dadurch die Kosten.

Ferner kann die Druckform mit geringeren Toleranzen gefertigt werden, wodurch sich die Qualität der Druckform erhöht. Dies liegt darin begründet, dass mit jedem Austausch der Halterung samt Druckform zwischen verschiedenen Fertigungsanlagen, insbesondere bei einem Entfernen und erneutem Aufziehen der Druckform auf verschiedene Halterungen, eine neue Positionierung der Druckform gegenüber dem jeweiligen Bearbeitungswerkzeug erfolgt, die stets eine gewisse Unsicherheit bei der Positionierung in sich birgt. Werden hingegen mehrere Herstellungsschritte auf derselben Fertigungsanlage ausgeführt, kann diese Unsicherheit in der Positionierung vermieden werden.

In einem weiteren Schritt kann dann die fertige Druckform samt Halterung aus der Fertigungsanlage und die Druckform von der Halterung z.B. mittels Druckluft von Innen oder Ansaugen von Außen entfernt werden. Die fertige Druckform kann dann z.B. mittels Druckluft von Innen oder Ansaugen von Außen auf einen Druckzylinder aufgebracht und zum Drucken verwendet werden.

Die Erfindung betrifft ferner eine Vorrichtung zur Bearbeitung einer Druckform bzw. dessen Druckformvorläufers wie zuvor beschrieben. Die Vorrichtung weist wenigstens ein erstes Bearbeitungswerkzeug zum Verringern der Schichtdicke der ersten Schicht der Druckform, vorzugsweise ein Schleifwerkzeug auf. Die Vorrichtung weist ferner ein weiteres Bearbeitungswerkzeug zur Ausbildung der Druckvorlage der ersten Schicht der Druckform auf, vorzugsweise einen Laser zum Abtrag von Material der ersten Schicht der Druckform.

Diese Vorrichtung betrifft den Gedanken, dass eine erfindungsgemäße Druckform einfacher und kostengünstiger weiterbearbeitet, z.B. die Druckvorlage auf die Druckform aufgebracht werden kann, als es bisher üblich ist. So kann erfindungsgemäß die extrudierte Druckform, die verfahrensbedingt bzw. gewünscht eine zumindest geringfügige Überdimensionierung der Druckschicht in radialer Richtung R sowie i.A. verfahrensbedingt eine unebene Oberfläche aufweist, in derselben Vorrichtung auf den gewünschten Rundlauf in Form der gewünschten Schichtdicke samt Oberflächenbeschaffenheit gebracht werden, in der auch die Ausarbeitung der Druckvorlage erfolgen kann.

Als eine solche Vorrichtung kommt z.B. eine Fertigungsanlage in Betracht, die eine Halterung vergleichbar einem Druckzylinder aufweist, auf dem eine Druckform samt oder auch ohne Festigkeitsträger aufgebracht werden kann, um sie hier zu bearbeiten.. Hierzu kann die extrudierte Druckform z.B. mittels Schleifen oder Drehen auf die gewünschte Schichtdicke gebracht werden. Zur Ausbildung der gewünschten Oberflächenbeschaffenheit kann die Druckform z.B. gefinished, poliert oder geschliffen werden. Diese beiden Vorgänge können in derselben Fertigungsanlage durch zwei verschiedene Bearbeitungswerkzeuge erfolgen. Es ist jedoch bevorzugt, diese beiden Vorgänge mit demselben Bearbeitungswerkzeug durchzuführen, das vorzugsweise ein Schleifwerkzeug ist.

In dieser Fertigungsanlage kann erfindungsgemäß ferner in einem nachfolgenden Schritten oder zeitgleich mit der zuvor beschriebenen Bearbeitung die Erstellung der Druckvorlage durch Abtrag der Vertiefungen bzw. Nichtbildstellen z.B. mittels Laser, Fräser oder dergleichen, vorzugsweise Laser, erfolgen. So ist es insbesondere vorteilhaft, diese Verfahrensschritte in einer Fertigungsanlage zu kombinieren, um Kosten und Zeit zu sparen. Beispielsweise kann auf diese Weise eine extrudierte Druckform in der Fertigungsanlage rotieren und durch ein erstes Bearbeitungswerkzeug wie vorzugsweise ein Schleifwerkzeug, das vorzugsweise in radialer Richtung R verstellbar ist, auf die gewünschte Schichtdicke und die gewünschte Oberflächenbeschaffenheit gebracht werden, und durch ein weiteres Bearbeitungswerkzeug wie vorzugsweise einem Laser, vorzugsweise einem Kohlendioxidlaser, einem Faserlaser oder einem Diodenlaser, derselben Fertigungsanlage die Druckvorlage durch Abtrag der entsprechenden Vertiefungen bzw. Nichtbildstellen der Druckvorlage herausgearbeitet werden.

Die Erfindung betrifft auch die Verwendung eines Schlauches, der ein Vulkanisat auf Basis wenigstens eines Elastomers aufweist, als Druckform bzw. als Druckformvorläufer für den Hochdruck, insbesondere den Flexodruck.

Diesem Aspekt der Erfindung liegt die Erkenntnis zugrunde, dass zur Herstellung einer Druckform, insbesondere zur Herstellung der Druckschicht einer Druckform, welches ein Vulkanisat auf Basis wenigstens eines Elastomers aufweist, im einfachsten Fall ein entsprechender Schlauch verwendet werden kann. Somit kann auf separate Herstellungsverfahren verzichtet werden und ein entsprechender Schlauch mittels der hierfür üblichen Verfahren hergestellt werden. Dieser Schlauch kann dann als Druckform verwendet werden, indem er direkt auf einen Druckzylinder ausgezogen und als Druckform verwendet wird.

Auch kann der Schlauch als Druckform auf einen Festigkeitsträger, insbesondere einen formstabilen Festigkeitsträger, aufgezogen und in dieser Kombination als Hülse verwendet werden. Die dabei entstehende Hülse kann dann nachfolgend wie eine bisher üblich hergestellte Hülse gehandhabt und weiterverarbeitet werden, so dass für den Anwender keine Umstellung gegenüber der bisherigen Erstellung und Verwendung einer Druckvorlage erfolgt. Jedoch können durch die erfindungsgemäße Herstellung der Hülse erhebliche Kosten eingespart werden, ohne die Qualität der Hülse zu verschlechtern.

Ein Ausführungsbeispiel und weitere Vorteile der Erfindung werden nachstehend im Zusammenhang mit den folgenden Figuren erläutert. Darin zeigt:
- Fig. 1a: eine perspektivische schematische Darstellung eines nicht erfindungsgemäßen zylindrischen Flächengebildes in Form einer Druckform gemäß einem ersten Ausführungsbeispiel;
- Fig. 1b: einen Halbschnitt durch die perspektivische schematische Darstellung der Fig. 1a;
- Fig. 2a: eine perspektivische schematische Darstellung eines erfindungsgemäßen zylindrischen Flächengebildes in Form einer Druckform gemäß einem zweiten Ausführungsbeispiel;
- Fig. 2b: einen Halbschnitt durch die perspektivische schematische Darstellung der Fig. 2a;
- Fig. 3a: eine perspektivische schematische Darstellung eines erfindungsgemäßen zylindrischen Flächengebildes in Form einer Druckform gemäß einem dritten Ausführungsbeispiel;
- Fig. 3b: einen Halbschnitt durch die perspektivische schematische Darstellung der Fig. 3a;
- Fig. 4a: eine perspektivische schematische Darstellung eines nicht erfindungsgemäßen zylindrischen Flächengebildes in Form einer Druckform gemäß dem ersten Ausführungsbeispiel, das auf einem Druckzylinder angeordnet ist;
- Fig. 4b: einen Halbschnitt durch die perspektivische schematische Darstellung der Fig. 4a;
- Fig. 5a: eine perspektivische schematische Darstellung eines nicht erfindungsgemäßen zylindrischen Flächengebildes in Form einer Druckform gemäß dem ersten Ausführungsbeispiel, das auf einem Festigkeitsträger angeordnet ist;
- Fig. 5b: einen Halbschnitt durch die perspektivische schematische Darstellung der Fig. 5a;
- Fig. 6a: eine perspektivische schematische Darstellung einer Fertigungsanlage zur Bearbeitung eines nicht erfindungsgemäßen zylindrischen Flächengebildes in Form einer Druckform gemäß dem ersten Ausführungsbeispiel, das auf einer Halterung angeordnet ist;
- Fig. 6b: einen Halbschnitt durch die perspektivische schematische Darstellung der Fig. 6a;
- Fig. 7a: eine perspektivische schematische Darstellung einer bevorzugten Fertigungsanlage zur Bearbeitung eines nicht erfindungsgemäßen zylindrischen Flächengebildes in Form einer Druckform gemäß dem ersten Ausführungsbeispiel, das auf einer Halterung angeordnet ist; und
- Fig. 7b: einen Halbschnitt durch die perspektivische schematische Darstellung der Fig. 7a.

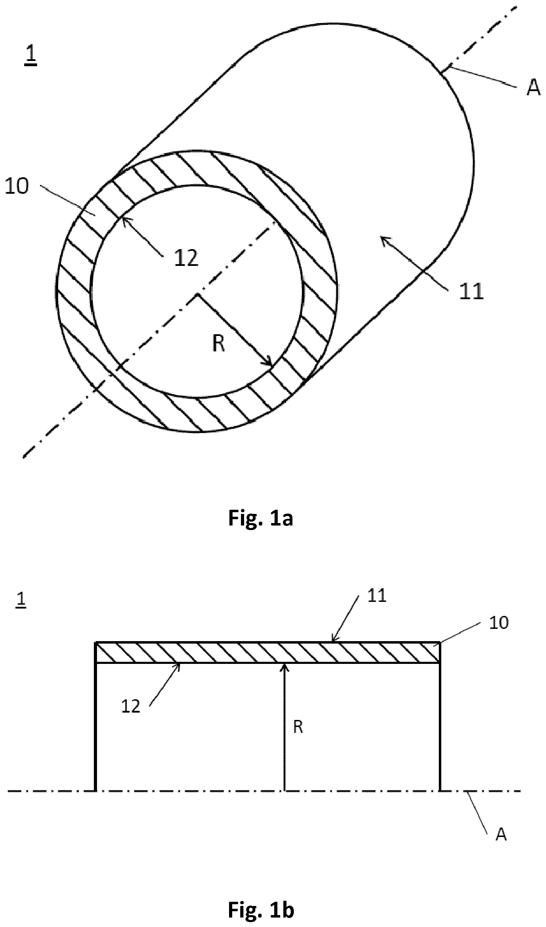

Fig. 1a zeigt eine perspektivische schematische Darstellung eines nicht erfindungsgemäßen zylindrischen Flächengebildes 1 in Form einer Druckform 1 gemäß einem ersten Ausführungsbeispiel. Fig. 1b zeigt einen Halbschnitt durch die perspektivische schematische Darstellung der Fig. 1a.

In diesem ersten Ausführungsbeispiel ist die Druckform 1 einschichtig aufgebaut und weist lediglich eine erste Schicht 10 auf. Die erste Schicht 10 stellt die Druckschicht 10 der Druckform 1 dar und kann durch einen Schlauch 1 gebildet werden. Die Druckschicht 10 weist in radialer R, die senkrecht zu der axialen Längsrichtung A der Druckform 1 ausgerichtet ist, nach Außen gerichtet eine Oberfläche 11 (äußere Oberfläche 11) auf, die die Druckoberfläche 11 der Druckform 1 darstellt. Auf der Druckschicht 10 werden zur Erstellung einer Druckvorlage (eines Druckreliefs) die Druckelemente bzw. Bildstellen herausgearbeitet.

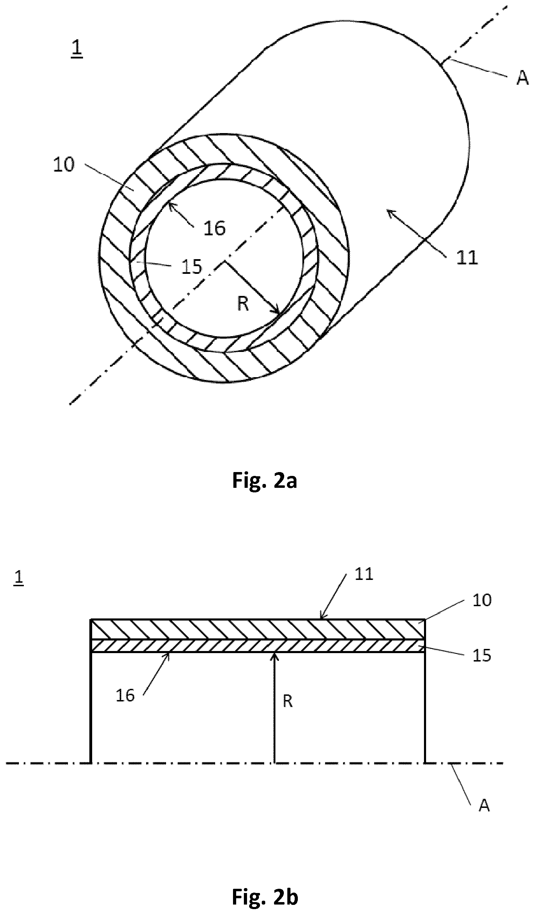

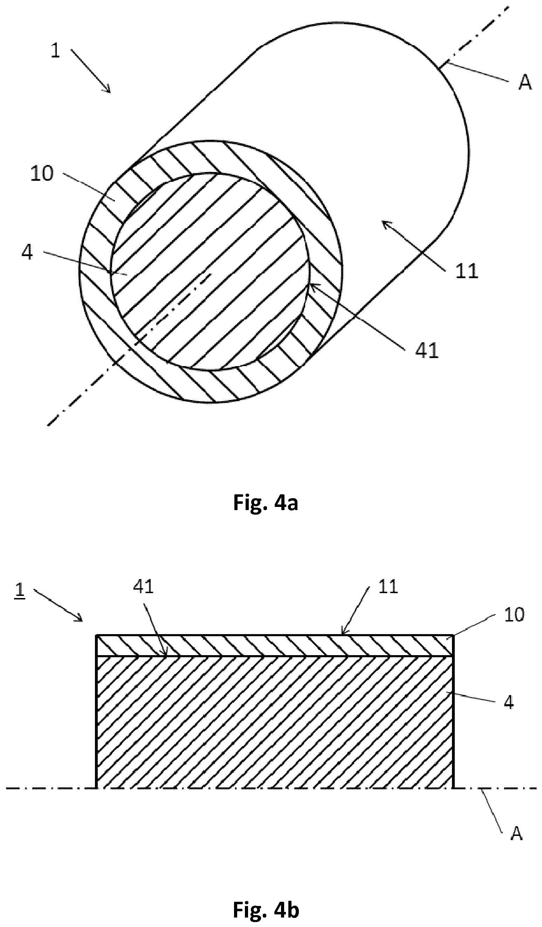

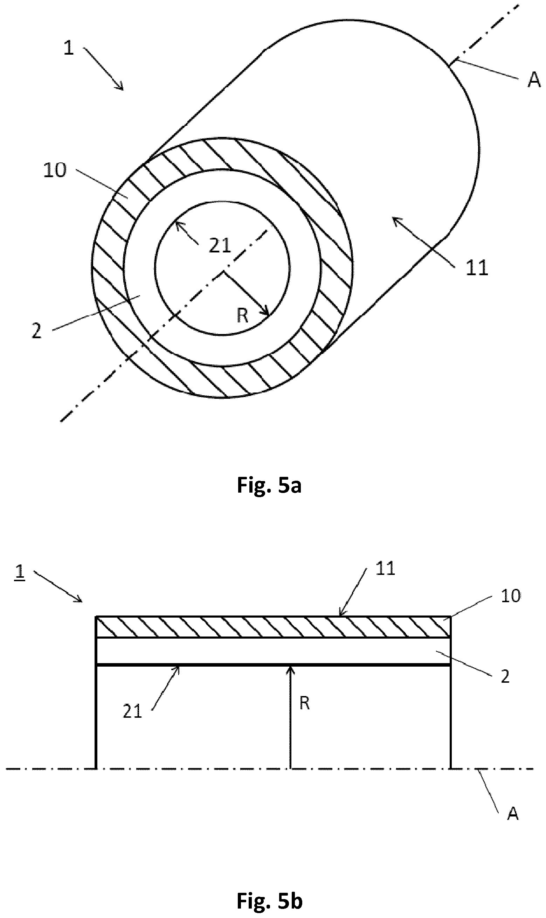

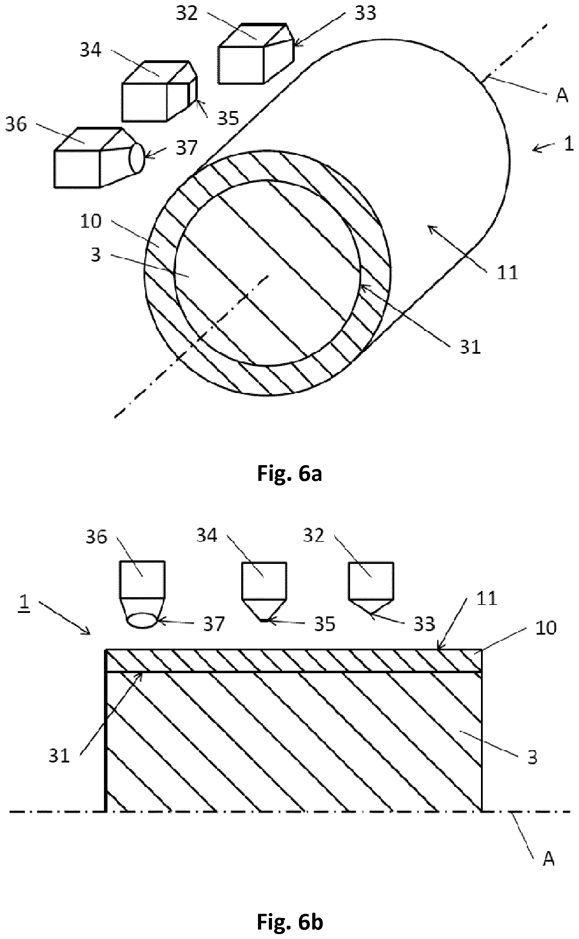

Die Druckschicht 10 weist ferner in radialer Richtung R nach Innen gerichtet eine Oberfläche 12 (innere Oberfläche 12) auf, die die Kontaktfläche 12 der Druckschicht 10 darstellt. Mit dieser Kontaktfläche 12 kann die Druckschicht 10 auf einer in radialer Richtung R unter ihr angeordneten Schicht oder auch Körper aufliegen. Dies können bei einer mehrschichtigen Ausgestaltung gemäß z.B. des zweiten oder dritten Ausführungsbeispiels der vorliegenden Erfindung eine weitere Schicht 15, 17 sein (vgl. Fig. 2a bis 3b). In dem ersten Ausführungsbeispiel ist jedoch die Druckform 1 ausschließlich aus der Druckschicht 10 aufgebaut. Entsprechend kann die Druckform 1 mit der Kontaktfläche 12 der Druckschicht 10 direkt auf einem Druckzylinder 4 (vgl. Fig. 34a und 4b), einer Halterung zur Bearbeitung (vgl. Fig. 6a und 6b) oder einem Festigkeitsträger 2, insbesondere einem formstabilen Festigkeitsträger 2 aufliegen (vgl. Fig. 5a und 5b).

Fig. 2a zeigt eine perspektivische schematische Darstellung eines erfindungsgemäßen zylindrischen Flächengebildes 1 in Form einer Druckform 1 gemäß einem zweiten Ausführungsbeispiel. Fig. 2b zeigt einen Halbschnitt durch die perspektivische schematische Darstellung der Fig. 2a.

In diesem zweiten Ausführungsbeispiel ist die Druckform 1 mehrschichtig aufgebaut und weist eine erste Schicht 10 als Druckschicht 10 und eine weitere Schicht 15 als Festigkeitsträgerschicht 15 in dieser Reihenfolge von Außen nach Innen in radialer Richtung R auf. Die Kontaktfläche 12 der Druckschicht 10 liegt dabei an der in radialer Richtung R äußeren Fläche der Festigkeitsträgerschicht 15 an. Die innere Oberfläche 16 der Festigkeitsträgerschicht 15 ist in radialer Richtung R nach innen gerichtet und stellt in diesem Ausführungsbeispiel die Kontaktfläche 16 dar, mit der die Druckform 1 auf einem Druckzylinder 4 (vgl. Fig. 4a und 4b), einer Halterung zur Bearbeitung (vgl. Fig. 6a und 6b) oder einem Festigkeitsträger 2, insbesondere einem formstabilen Festigkeitsträger 2 aufliegen kann (vgl. Fig. 5a und 5b).

Die Festigkeitsträgerschicht 15 kann z.B. Gestrick, Geflecht oder Gewirk aufweisen und als separate Schicht, wie in den Fig. 2a und 2b dargestellt, oder auch als Bestandteil der Druckschicht 10 ausgebildet sein. Die Festigkeitsträgerschicht 15 dient dabei der Erhöhung der Stabilität der Druckform 1, ohne jedoch dessen elastische Eigenschaften aufzuheben. So ist die Festigkeitsträgerschicht 15 als Bestandteil der Druckform 1 nicht mit einem Festigkeitsträger 2, insbesondere einem formstabilen Festigkeitsträger 2 zu verwechseln, auf den als separates Element die Druckform 1 gegebenenfalls aufgezogen werden kann (vgl. Fig. 5a und 5b).

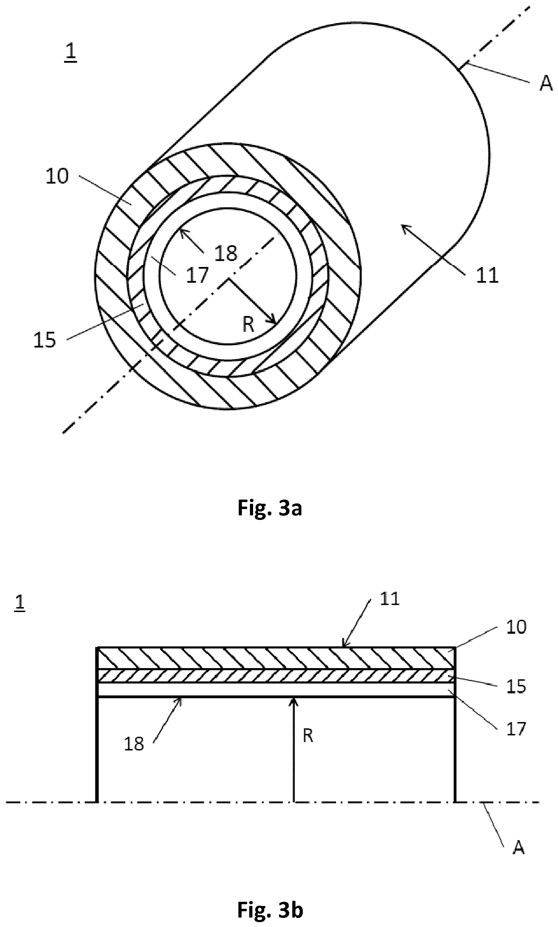

Fig. 3a zeigt eine perspektivische schematische Darstellung eines erfindungsgemäßen zylindrischen Flächengebildes 1 in Form einer Druckform 1 gemäß einem dritten Ausführungsbeispiel. Fig. 3b zeigt einen Halbschnitt durch die perspektivische schematische Darstellung der Fig. 3a.

In diesem dritten Ausführungsbeispiel ist die Druckform 1 mehrschichtig aufgebaut und weist eine erste Schicht 10 als Druckschicht 10, eine weitere Schicht 15 als Festigkeitsträgerschicht 15 sowie eine weitere Schicht als kompressible Schicht 17 (Kompressionsschicht 17) in dieser Reihenfolge von Außen nach Innen in radialer Richtung R auf. Die Kontaktfläche 12 der Druckschicht 10 liegt dabei an der in radialer Richtung R äußeren Fläche der Festigkeitsträgerschicht 15 an. Die Kontaktfläche 16 der Festigkeitsträgerschicht 15 liegt an der in radialer Richtung R äußeren Fläche der kompressiblen Schicht 17 an. Die innere Oberfläche 18 der kompressiblen Schicht 17 ist in radialer Richtung R nach innen gerichtet und stellt in diesem Ausführungsbeispiel die Kontaktfläche 18 dar, mit der die Druckform 1 auf einem Druckzylinder 4 (vgl. Fig. 4a und 4b) einer Halterung zur Bearbeitung (vgl. Fig. 6a und 6b) oder einem Festigkeitsträger 2, insbesondere einem formstabilen Festigkeitsträger 2 aufliegen kann (vgl. Fig. 5a und 5b). Die kompressible Schicht 17 kann z.B. Mikrokugeln aus Kunststoff in einer Gummimischung oder ein mikroporöses Zellengebilde mit eingeschlossenen Gaskammern (Schaumstoffe) aufweisen, um eine kompressible Wirkung zu erzeugen.

Alternativ zu der in den Fig. 3a und 3b dargestellten Reihenfolge können die Festigkeitsträgerschicht 15 und die kompressible Schicht 17, in einer nicht erfindungsgemäßen Ausführungsform, auch in umgekehrter Reihenfolge innerhalb der Druckschicht 10 in radialer Richtung R vorgesehen sein.

Ferner kann in jedem der zuvor beschriebenen Ausführungsbeispiele in dem Material der Druckschicht 10 aber auch in den Materialien der Festigkeitsträgerschicht 15 und bzw. oder der kompressiblen Schicht 17 ein magnetisches oder magnetisierbares Material vorgesehen sein, um z.B. die Druckform 1 mittels magnetischer Kräfte auf einem Untergrund wie z.B. einem Druckzylinder 4 (vgl. Fig. 4a und 4b), einer Halterung zur Bearbeitung (vgl. Fig. 6a und 6b) oder einem Festigkeitsträger 2, insbesondere einem formstabilen Festigkeitsträger 2 anhaften zu lassen (vgl. Fig. 5a und 5b).

Fig. 4a zeigt eine perspektivische schematische Darstellung eines nicht erfindungsgemäßen zylindrischen Flächengebildes 1 in Form einer Druckform 1 gemäß dem ersten Ausführungsbeispiel, das auf einem Druckzylinder 4 angeordnet ist. Fig. 4b zeigt einen Halbschnitt durch die perspektivische schematische Darstellung der Fig. 4a. Die Bezugszeichen der Druckform 1 entsprechen denen der Fig. 1a und 1b. Der Druckzylinder 4 weist eine Oberfläch 41 in radialer Richtung R nach Außen gerichtet auf, auf der die Druckform 1 mit der Kontaktfläche 12 seiner Druckschicht 10 direkt aufliegt. Somit kann auf die Verwendung eines Festigkeitsträgers 2, insbesondere eines formstabilen Festigkeitsträgers 2 verzichtet werden, um eine Druckform 1 herzustellen und anschließend auf einem Druckzylinder 4 zu verwenden.

Die Darstellungen der Fig. 4a und 4b zeigen beispielhaft für die Druckform 1 des ersten Ausführungsbeispiels, wie eine Druckform 1 direkt auf einem Druckzylinder 4 vorgesehen werden kann. Dabei kann alternativ auch eine Druckform 1 gemäß dem zweiten oder dritten Ausführungsbeispiel oder gemäß einer weiteren Ausgestaltung hierzu verwendet werden. Diese liegt dann mit der Kontaktfläche 16 der Festigkeitsträgerschicht 15 bzw. mit der Kontaktfläche 18 der kompressiblen Schicht 17 auf der Oberfläche 41 des Druckzylinders 4 auf.

Fig. 5a zeigt eine perspektivische schematische Darstellung eines nicht erfindungsgemäßen zylindrischen Flächengebildes 1 in Form einer Druckform 1 gemäß dem ersten Ausführungsbeispiel, das auf einem Festigkeitsträger 2 angeordnet ist. Fig. 5b zeigt einen Halbschnitt durch die perspektivische schematische Darstellung der Fig. 5a. Die Bezugszeichen der Druckform 1 entsprechen denen der Fig. 1a und 1b. Der Festigkeitsträger 2 weist eine Oberfläch 21 in radialer Richtung R nach Außen gerichtet auf, auf der die Druckform 1 mit der Kontaktfläche 12 seiner Druckschicht 10 direkt aufliegt. Die Kombination von Druckform 1 und Festigkeitsträger 2 kann als Hülse, Druckhülse, Sleeve oder auch Trägersleeve bezeichnet werden.

Dabei kann dieser Kontakt beispielsweise dadurch hergestellt werden, dass die Druckform 1 mittels Druckluft von Innen oder Ansaugen mittels eines Vakuums von Außen gedehnt und der Festigkeitsträger 2 in die gedehnte Druckform 1 eingeführt wird. Wird dann die Druckluft oder das Vakuum entfernt, zieht sich das elastische Material der Druckform 1 wieder zusammen und die Druckform 1 liegt dann auf dem Festigkeitsträger 2 an, ohne dauerhaft mit diesem verbunden zu sein, d.h. ohne so mit diesem verbunden zu sein, dass es nur mittels Zerstörung wieder von diesem entfernt werden könnte.

Die Darstellungen der Fig. 5a und 5b zeigen beispielhaft für die Druckform 1 des ersten Ausführungsbeispiels, wie eine Druckform 1 direkt auf einem Festigkeitsträger 2 vorgesehen werden kann. Dabei kann alternativ auch eine Druckform 1 gemäß dem zweiten oder dritten Ausführungsbeispiel oder gemäß einer weiteren Ausgestaltung hierzu verwendet werden. Diese liegt dann mit der Kontaktfläche 16 der Festigkeitsträgerschicht 15 bzw. mit der Kontaktfläche 18 der kompressiblen Schicht 17 auf der Oberfläche 21 des Festigkeitsträgers 2 auf.

Fig. 6a zeigt eine perspektivische schematische Darstellung einer Fertigungsanlage zur Bearbeitung eines nicht erfindungsgemäßen zylindrischen Flächengebildes 1 in Form einer Druckform 1 gemäß dem ersten Ausführungsbeispiel, das auf einer Halterung 3 angeordnet ist. Fig. 6b zeigt einen Halbschnitt durch die perspektivische schematische Darstellung der Fig. 6a. Die Bezugszeichen der Druckform 1 entsprechen denen der Fig. 1a und 1b. Die Halterung 3 weist eine Oberfläch 31 in radialer Richtung R nach Außen gerichtet auf, auf der die Druckform 1 mit der Kontaktfläche 12 seiner Druckschicht 10 direkt aufliegt.

Dabei kann dieser Kontakt beispielsweise dadurch hergestellt werden, dass die Druckform 1 mittels Druckluft von Innen oder Ansaugen mittels eines Vakuums von Außen gedehnt und die Halterung 3 in die gedehnte Druckform 1 eingeführt wird. Wird dann die Druckluft oder das Vakuum entfernt, zieht sich das elastische Material der Druckform 1 wieder zusammen und die Druckform 1 liegt dann auf die Halterung 3 an, ohne dauerhaft mit diesem verbunden zu sein, d.h. ohne so mit diesem verbunden zu sein, dass es nur mittels Zerstörung wieder von diesem entfernt werden könnte.

Die Halterung 3 kann samt Druckform 1 z.B. in einer Fertigungsanlage (Bearbeitungsmaschine) aufgenommen und dort um die Längsachse A der Druckform 1 rotiert werden, um die Oberfläche 11 der Druckschicht 10 zu bearbeiten. Dies kann beispielsweise mittels eines ersten Bearbeitungswerkzeugs 32 geschehen, das zum Schichtabtrag der Druckschicht 10 vorgesehen ist. Hierzu kann z.B. ein Schneidwerkzeug 33 verwendet werden, welches feststehend in dem Bearbeitungswerkzeug 32 vorgesehen ist und dessen Schneidwerkzeug 33 derart ausgerichtet und durch das Bearbeitungswerkzeug 32 in radialer Richtung R gegenüber der Oberfläche 11 des Druckschicht 10 positioniert werden kann, dass die Schneidkante des Schneidwerkzeugs 33 mit dem Material der Druckschicht 10 in Eingriff kommt und diese durch die Rotation der Halterung 3 samt Druckform 1 auf die gewünschte Schichtdicke spanend durch einen Drehprozess abträgt. Alternativ können hierzu auch andere Prozesse wie Schneiden, Schleifen, Strahlen (Wasserstrahlen, Sandstrahlen) und dergleichen verwendet werden, wobei ein Schleifprozess bevorzugt ist.

Ist vor der Ausbildung der Druckvorlage der Druckschicht 10 die Schaffung einer gewünschten Oberflächenqualität der Oberfläche 11 der Druckschicht 10 erforderlich bzw. gewünscht, so kann dies zum Einen dadurch erfolgen, dass das erste Bearbeitungswerkzeugs 32 durch Austausch des Schneidwerkzeugs 33 hierzu verwendet wird. Hierzu können z.B. Prozesse wie das Schleifen, Polieren, Finishen und dergleichen eingesetzt werden. So ist es z.B. möglich, in einem ersten Schritt in der Fertigungsanlage mittels eines ersten Schneidwerkzeugs 33 mit dem ersten Bearbeitungswerkzeug die gewünschte Schichtdicke der Druckschicht 10 herzustellen, das Schneidwerkzeug 33 auszutauschen und in einem zweiten Bearbeitungsschritt in der Fertigungsanlage mit dem ersten Bearbeitungswerkzeug 32 die gewünschte Oberflächenqualität der Oberfläche 11 der Druckschicht 10 z.B. mittels eines Schleifwerkzeugs 35 herzustellen.

Zum Anderen können auch zwei Bearbeitungswerkzeuge 32, 34, die in der Abfolge der Bearbeitungsschritte hintereinander in der Fertigungsanlage angeordnet sind, diese Bearbeitungsschritte parallel zueinander gleichzeitig an verschiedenen Stellen der Druckform 1 durchgeführt werden. Hierzu kann die Fertigungsanlage ein zweites Bearbeitungswerkzeug 34 mit z.B. einem Schleifwerkzeug 35 aufweisen.

Schließlich kann mittels eines dritten Bearbeitungswerkzeugs 36 die Ausbildung der Druckvorlage der Druckschicht 10 erfolgen. Hierzu kann z.B. ein Laser 37 oder auch Fräser 37 verwendet werden, um die Druckelemente bzw. Bildstellen der Druckvorlage durch Abtrag der Vertiefungen bzw. Nichtbildstellen herauszuarbeiten, wobei ein Laser 37 bevorzugt ist. Das dritte Bearbeitungswerkzeug 36 kann dabei so in der Fertigungsanlage angeordnet sein, dass es feststehend sowie räumlich und zeitlich so gegenüber dem ersten Bearbeitungswerkzeug 32 und dem zweiten Bearbeitungswerkzeug 34 angeordnet ist, dass die drei Bearbeitungsschritte auch parallel zueinander gleichzeitig an verschiedenen Stellen der Druckform 1 durchgeführt werden können. Dabei kann auch das dritte Bearbeitungswerkzeug 36 ebenso wie das erste Bearbeitungswerkzeug 32 und das zweite Bearbeitungswerkzeug 34 in radialer Richtung R gegenüber der Druckform 1 positionierbar vorgesehen sein.

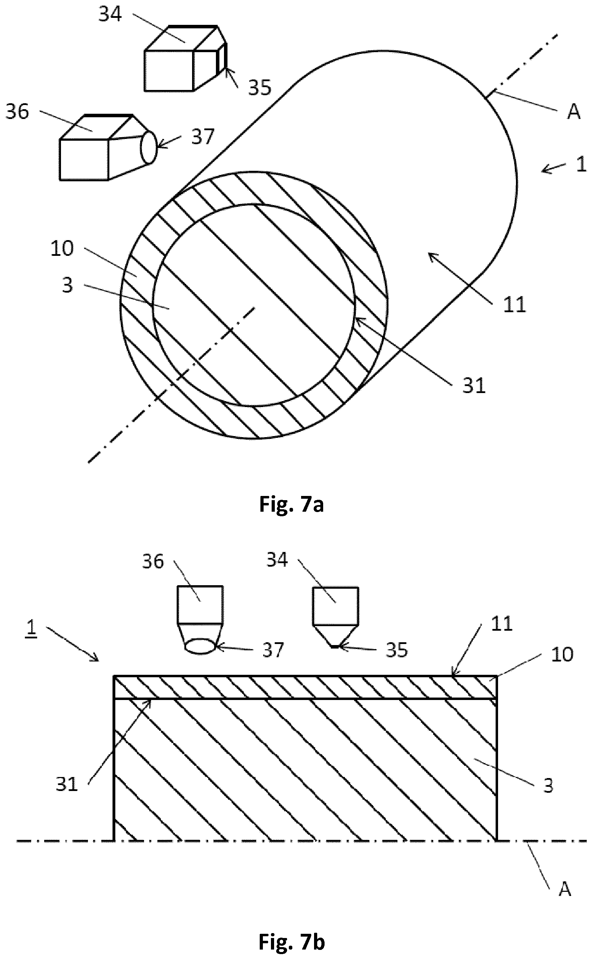

Fig. 7a zeigt eine perspektivische schematische Darstellung einer bevorzugten Fertigungsanlage zur Bearbeitung eines nicht erfindungsgemäßen zylindrischen Flächengebildes 1 in Form einer Druckform 1 gemäß dem ersten Ausführungsbeispiel, das auf einer Halterung 3 angeordnet ist. Fig. 7b zeigt einen Halbschnitt durch die perspektivische schematische Darstellung der Fig. 7a. Die Bezugszeichen der Druckform 1 entsprechen denen der Fig. 1a und Die Bezugszeichen der Fertigungsanlage entsprechen denen der Fig. 6a und 6b.

In dieser bevorzugten Fertigungsanlage werden das erste Bearbeitungswerkzeug 32 und das zweite Bearbeitungswerkzeug 34 miteinander dadurch kombiniert und gemeinsam als zweites Bearbeitungswerkzeug 34 bezeichnet, dass das zweite Bearbeitungswerkzeug 34 als Schleifwerkzeug 35 derart ausgebildet ist, dass es sowohl den Schichtabtrag als auch die Bearbeitung der Oberflächenbeschaffenheit vornehmen kann. Hierdurch kann ein Fertigungsschritt und das entsprechende separate Bearbeitungswerkzeug 32 eingespart werden.

### Bezugszeichenliste

### (Teil der Beschreibung)

- A: axiale Richtung der Druckform 1 bzw. des Festigkeitsträgers 2
- R: radiale Richtung der Druckform 1 bzw. des Festigkeitsträgers 2, senkrecht zur axialen Richtung A
- 1: Druckform (ein- oder mehrschichtiges zylindrisches Flächengebilde, Schlauch)
- 10: erste Schicht der Druckform 1, Druckschicht
- 11: äußere Oberfläche der ersten Schicht 10, Druckoberfläche der Druckform 1
- 12: innere Oberfläche der ersten Schicht 10, Kontaktfläche der Druckschicht
- 15: weitere Schicht der Druckform 1, Festigkeitsträgerschicht
- 16: innere Oberfläche der Festigkeitsträgerschicht 15, Kontaktfläche der Festigkeitsträgerschicht 15
- 17: weitere Schicht der Druckform 1, kompressible Schicht, Kompressionsschicht
- 18: innere Oberfläche der kompressiblen Schicht 17, Kontaktfläche der kompressiblen Schicht 18
- 2: Festigkeitsträger, insbesondere formstabiler Festigkeitsträger
- 3: Halterung zur Bearbeitung einer Druckform 1
- 31: innere Oberfläche der Halterung 3, Kontaktfläche der Halterung 3
- 32: erstes Bearbeitungswerkzeug zum Schichtabtrag der Druckschicht 10
- 33: Schneidwerkzeug des ersten Bearbeitungswerkzeugs 32
- 34: zweites Bearbeitungswerkzeug zur Herstellung einer gewünschten Oberflächenqualität der Oberfläche 11 der Druckschicht 10
- 35: Schleifwerkzeug des dritten Bearbeitungswerkzeugs 34
- 36: drittes Bearbeitungswerkzeug zur Ausbildung der Druckvorlage der Druckschicht 10
- 37: Laser oder Fräser des dritten Bearbeitungswerkzeugs 36
- 4: Druckzylinder
- 41: äußere Oberfläche des Druckzylinders 4

## Patentansprüche

1. Druckformvorläufer zur Verwendung für den Hochdruck, insbesondere den Flexodruck, der als mehrschichtiger Schlauch ausgebildet ist, mit einer ersten Schicht (10) als Druckschicht (10), die ein Vulkanisat auf Basis wenigstens eines Elastomers aufweist,
wobei die erste Schicht (10) extrudiert ist, und
einer weiteren Schicht (15), die als Festigkeitsträgerschicht (15) ausgebildet ist, wobei die Festigkeitsträgerschicht (15) radial innerhalb der ersten Schicht (10) angeordnet ist und in direktem Kontakt mit der ersten Schicht (10) steht,
**dadurch gekennzeichnet, dass**
die Festigkeitsträgerschicht (15) ein oder mehrere Textilgebilde aufweist.

2. Druckformvorläufer nach Anspruch 1,
mit einer weiteren Schicht (17), die als kompressible Schicht (17) ausgebildet ist, wobei die kompressible Schicht (17) radial innerhalb der Festigkeitsträgerschicht (15) angeordnet ist und in direktem Kontakt mit der Festigkeitsträgerschicht (15) steht.

3. Druckformvorläufer nach einem der Ansprüche 1 oder 2,
wobei wenigstens eine Schicht (10, 15, 17) ein magnetisches oder magnetisierbares Material aufweist.

4. Druckform (1) zur Verwendung für den Hochdruck, insbesondere den Flexodruck, der als mehrschichtiger Schlauch ausgebildet ist, mit
einer ersten Schicht (10) als Druckschicht (10), die ein Vulkanisat auf Basis wenigstens eines Elastomers aufweist,
wobei die erste Schicht (10) extrudiert ist, und
einer weiteren Schicht (15), die als Festigkeitsträgerschicht (15) ausgebildet ist, wobei die Festigkeitsträgerschicht (15) radial innerhalb der ersten Schicht (10) angeordnet ist und in direktem Kontakt mit der ersten Schicht (10) steht,
**dadurch gekennzeichnet, dass**
die Festigkeitsträgerschicht (15) ein oder mehrere Textilgebilde aufweist.

5. Druckform (1) nach Anspruch 4,
mit einer weiteren Schicht (17), die als kompressible Schicht (17) ausgebildet ist, wobei die kompressible Schicht (17) radial innerhalb der Festigkeitsträgerschicht (15) angeordnet ist und in direktem Kontakt mit der Festigkeitsträgerschicht (15) steht.

6. Druckform (1) nach einem der Ansprüche 4 oder 5,
wobei wenigstens eine Schicht (10, 15, 17) ein magnetisches oder magnetisierbares Material aufweist.

## Claims

1. Printing plate precursor for use in relief printing, in particular flexo printing, said printing plate precursor being configured as a multi-layer tube having
a first layer (10) as a printing layer (10) which has a vulcanized product based on at least one elastomer, wherein the first layer (10) is extruded; and
a further layer (15) which is configured as a reinforcement layer (15), wherein the reinforcement layer (15) is disposed so as to be radially within the first layer (10) and is in direct contact with the first layer (10),
**characterized in that**
the reinforcement layer (15) has one or a plurality of textile structures.

2. Printing plate precursor according to Claim 1, having a further layer (17) which is configured as a compressible layer (17), wherein the compressible layer (17) is disposed so as to be radially within the reinforcement layer (15) and is in direct contact with the reinforcement layer (15).

3. Printing plate precursor according to one of Claims 1 or 2,
wherein at least one layer (10, 15, 17) comprises a magnetic or magnetizable material.

4. Printing plate (1) for use in relief printing, in particular flexo printing, said printing plate (1) being configured as a multi-layer tube having
a first layer (10) as a printing layer (10) which has a vulcanized material based on at least one elastomer, wherein the first layer (10) is extruded; and
a further layer (15) which is configured as a reinforcement layer (15), wherein the reinforcement layer (15) is disposed so as to be radially within the first layer (10) and is in direct contact with the first layer (10),
**characterized in that**
the reinforcement layer (15) has one or a plurality of textile structures.

5. Printing plate (1) according to Claim 4,
having a further layer (17) which is configured as a compressible layer (17), wherein the compressible layer (17) is disposed so as to be radially within the reinforcement layer (15) and is in direct contact with the reinforcement layer (15).

6. Printing plate (1) according to one of Claims 4 or 5,
wherein at least one layer (10, 15, 17) comprises a magnetic or magnetizable material.

## Revendications

1. Précurseur de cliché à utiliser en typographie, en particulier en flexographie, qui est formé par un tuyau flexible multicouche, avec une première couche (10) comme couche d'impression (10), qui présente un vulcanisat à base d'au moins un élastomère, dans lequel la première couche (10) est extrudée, et avec une autre couche (15), qui est formée par une couche d'élément de résistance (15), dans lequel la couche d'élément de résistance (15) est disposée radialement à l'intérieur de la première couche (10) et se trouve en contact direct avec la première couche (10), **caractérisé en ce que** la couche d'élément de résistance (15) présente un ou plusieurs produit(s) textile(s).

2. Précurseur de cliché selon la revendication 1, avec une autre couche (17), qui est formée par une couche compressible (17), dans lequel la couche compressible (17) est disposée radialement à l'intérieur de la couche d'élément de résistance (15) et se trouve en contact direct avec la couche d'élément de résistance (15).

3. Précurseur de cliché selon une des revendications 1 ou 2, dans lequel au moins une couche (10, 15, 17) présente un matériau magnétique ou magnétisable.

4. Cliché (1) à utiliser en typographie, en particulier en flexographie, qui est formé par un tuyau flexible multicouche, avec une première couche (10) comme couche d'impression (10), qui présente un vulcanisat à base d'au moins un élastomère, dans lequel la première couche (10) est extrudée, et avec une autre couche (15), qui est formée par une couche d'élément de résistance (15), dans lequel la couche d'élément de résistance (15) est disposée radialement à l'intérieur de la première couche (10) et se trouve en contact direct avec la première couche (10), **caractérisé en ce que** la couche d'élément de résistance (15) présente un ou plusieurs produit(s) textile(s).

5. Cliché (1) selon la revendication 4, avec une autre couche (17), qui est formée par une couche compressible (17), dans lequel la couche compressible (17) est disposée radialement à l'intérieur de la couche d'élément de résistance (15) et se trouve en contact direct avec la couche d'élément de résistance (15).

6. Cliché (1) selon une des revendications 4 ou 5, dans lequel au moins une couche (10, 15, 17) présente un matériau magnétique ou magnétisable.
